# EUROPEAN PATENT APPLICATION

(11) **EP 4 394 884 A2**
(43) Date of publication of application: **03.07.2024**
(21) Application number: 23218249.3
(22) Date of filing: 19.12.2023
(51) Int. Cl.: H01L 29/10, H01L 29/808, H01L 29/06

(54) **TRANSISTOR WITH INTEGRATED SOURCE-DRAIN DIODE**

(30) Priority: 29.12.2022 US 202263477724 P; 08.12.2023 US 202318533355
(71) Applicant: Qorvo US, Inc., Greensboro, NC 27409 (US)
(72) Inventor: BHALLA, Anup, New Jersey, 08450 (US); FURSIN, Lenoid, New Jersey, 08540 (US)
(74) Representative: D Young & Co LLP

(57) **Abstract**

Vertical junction field-effect transistors (VJFETs) with integrated source-drain anti-parallel diodes are described. In an embodiment, a trench VJFET with integrated source-drain anti-parallel diodes structure is coupled with a low-voltage metal oxide semiconductor field-effect transistor (MOSFET) in a dual gate cascode configuration.

## Description

### Related Applications

This application claims the benefit of provisional patent application serial number 63/477,724, filed December 29, 2022, the disclosure of which is hereby incorporated herein by reference in its entirety.

### Field of the Disclosure

The present disclosure relates generally to semiconductor technology and in particular to depletion-mode trench gate vertical junction field-effect transistors with integrated source-drain anti-parallel diodes.

### Background

Vertical junction field-effect transistors (VJFETs) built on silicon carbide (SiC) are of great interest for high-power conversion applications and power electronic circuits. Conventional trench VJFET structures are created by etching trenches into a topside of a semiconductor material wherein gate regions are formed on both sides and bottoms of the trenches such that mirror-image replicates of gate regions and gate electrodes are formed on either side of each channel region. Therefore, both electrodes on either side of channel regions of conventional VJFETs are gate electrodes, controlling the current flow between drain and source, and creating a high gate-drain capacitance (C_{GD}) and gate-source capacitance (C_{GS}). Furthermore, in conventional VJFETs a reverse current (also referred to as source-drain current or 3rd quadrant current) conduction path does not exist, and current flow between drain and source approaches zero during their operation in the off-state. Such feature, namely having a bi-directional current flow or providing a 3rd quadrant current-conduction path with a reduced source-drain voltage (V_{SD}) drop, may be utilized in power converter topologies and applications.

Moreover, while a dual gate cascode structure of a VJFET in series with a low-voltage metal oxide semiconductor field-effect transistor (MOSFET) (herein after referred to as the "cascode structure") reduces the on-state resistance by driving the VJFET into positive V_{GS} values and provides an improved control of switching characteristics by enabling the gate of the VJFET device to be directly driven; nonetheless, cascode structures utilized in hard switching applications experience excessive 3rd quadrant energy losses due to the 3rd quadrant current (I_{SD}) flowing through the VJFET channel region and the source-drain voltage (V_{SD}) exceeding the absolute value of VJFET's threshold voltage (Vₜₕ).

For these and other reasons, there is a general need to reduce the structural gate-drain capacitance (C_{GD}) and gate-source capacitance (C_{GS}) of VJFET structures with a minimal impact to their on-state operation behavior. Furthermore, having a 3rd quadrant current conduction path with a minimal source-drain voltage (V_{SD}) drop and a specific on-resistance in cascode configuration is desired. A reduced specific on-resistance in cascode configuration provides a better control over switching characteristics of the cascode structure, leading to a reduction in energy losses.

The present disclosure provides improved design structures through incorporation of anti-parallel source-drain diode cells into depletion-mode trench VJFET cells. The integration of an anti-parallel source-drain diode cell into a depletion-mode trench VJFET cell reduces the structural gate-drain capacitance (C_{GD}), gate-source capacitance (C_{GS}), and switching energy losses. Said integration further reduces the saturation current density (Jₛₐₜ) while maintaining the same threshold voltage (Vₜₕ) with minimal impact on the specific on-resistance (R_{ds}A) of trench VJFET cells.

Depletion-mode trench VJFET cells with integrated source-drain diodes maintain an improved switching performance and reduced switching losses. A reduction in saturation current density provides a longer cascode short-circuit withstand time and an improved safe-operating area (SOA). In the event of a 3rd quadrant current surge, the current is uniformly distributed across the active area of the body region, which reduces the probability of a stacking fault growth. Lastly, having a directly accessible gate electrode forms a dual gate cascode configuration, which allows the VJFET's channel to be turned on during the 3rd quadrant operation.

### Summary

Particular embodiments are set out in the independent claims. Various optional examples are set out in the dependent claims. Embodiments of the present disclosure provide vertical junction field-effect transistors (VJFETs) monolithically integrated with anti-parallel PN diodes. These structures can be connected in series with a low-voltage metal oxide semiconductor field-effect transistor (MOSFET) to form a dual gate cascode structure.

In one aspect, a semiconductor structure comprising a drain-cathode electrode, a substrate over the drain-cathode electrode, and a body region over the substrate is disclosed wherein the body region comprises a top surface, a first source region extending into the body region from the top surface, a first
U-shaped gate region having a portion below the first source region and defining a first gate trench, and a U-shaped anode region having a first portion below the first source region and defining an anode trench. The semiconductor structure further comprises a first source electrode over the first source region and between the first gate trench and the anode trench, a first gate electrode over a portion of a bottom surface of the first gate trench, and an anode electrode over a portion of a bottom of the anode trench, wherein the first source electrode and the anode electrode are electrically coupled, the first gate region forms part of a first vertical junction field-effect transistor (JFET) cell, and the anode region forms part of a vertical diode cell, which is coupled anti-parallel with the first vertical JFET cell. The substrate and the body region may comprise silicon carbide. The first gate region and the anode region may be doped with a p-type dopant and a remaining portion of the body region and the substrate may be doped with an n-type dopant.

In an embodiment, the first source electrode and the anode electrode may integrally form part of a continuous electrode structure that covers at least a portion of the first source region, a portion of a first side wall of the anode trench, and a portion of the bottom of the anode trench. In an alternative embodiment, the first source electrode and the anode electrode integrally form part of a continuous electrode structure that covers at least a portion of the first source region, a first side wall of the anode trench, and the bottom of the anode trench.

The body region further comprises a first channel region below the first source region and between the first gate region and the anode region. The semiconductor structure may further comprise a secondary channel region doped with an n-type dopant and extending vertically into a central region within the first channel region wherein the maximum doping concentration of the secondary channel region is at least 50% higher than minimum doping concentration of the first channel region. In another embodiment, the semiconductor structure comprises a pair of secondary channel regions doped with n-type dopants and extending on the vertical inner walls within the first channel region wherein the maximum doping concentration of the secondary channel regions is at least 50% higher than minimum doping concentration of the first channel region.

The semiconductor structure may further comprise a second source region extending into the body region from the top surface, a second U-shaped gate region having a portion below the second source region and defining a second gate trench wherein the anode region has a second portion below the second source region such that the anode trench is between the first gate trench and the second gate trench, a second source electrode over the second source region and between the second gate trench and the anode trench, and a second gate electrode over a portion of a bottom surface of the second gate trench, wherein the first source electrode, the second source electrode, and the anode electrode are electrically coupled, wherein the second gate region forms part of a second vertical JFET cell located on the opposite side of the first vertical JFET cell from the vertical diode cell, and the vertical diode cell is coupled anti-parallel with the first vertical JFET cell and the second vertical JFET cell. The substrate and the body region may comprise silicon carbide. The first gate region, the second gate region, and the anode region may be doped with a p-type dopant and remaining portions of the body region and the substrate are doped with an
n-type dopant.

In an embodiment, the first source electrode, the second source electrode, and the anode electrode integrally form part of a continuous electrode structure that covers at least a portion of the first source region, at least a portion of the second source region, a portion of a first side wall of the anode trench, a portion of the bottom of the anode trench, and a portion of second side wall of the anode trench. Alternatively, the first source electrode, the second source electrode, and the anode electrode integrally form part of a continuous electrode structure that covers at least a portion of the first source region, a portion of the second source region, a first side wall of the anode trench, the bottom of the anode trench, and a second side wall of the anode trench.

The semiconductor structure further comprises a dielectric material filling portions of the first gate trench and the second gate trench to isolate the first gate electrode from the first source electrode and to isolate the second gate electrode from the second source electrode. The semiconductor structure further comprises a first metal overlay over the first source electrode, the second source electrode, the first gate trench, the anode trench, and the second gate trench.

The body region may further comprise a drift layer above the substrate and doped with an n-type dopant. The body region may further comprise a current spreading layer above the drift layer and below the first gate region and the second gate region and doped with an n-type dopant.

In an embodiment, the body region comprises a first channel region below the first source region and between the first gate region and the anode region and a second channel region below the second source region between the second gate region and the anode region. The semiconductor structure may comprise a first secondary channel region doped with an n-type dopant and extending vertically into a central region of the first channel region and a second secondary channel region doped with an n-type dopant and extending vertically into a central region of the second channel region wherein the maximum doping concentration of the secondary channel region is at least 50% higher than minimum doping concentration of the first channel region. Alternatively, the semiconductor structure may comprise a first pair of secondary channel regions doped with an n-type dopant and extending on the vertical inner walls within the first channel region and a second pair of secondary channel regions doped with an n-type dopant and extending on the vertical inner walls within the second channel region wherein the maximum doping concentrations of the first secondary channel regions and the second secondary channel regions are at least 50% higher than minimum doping concentration of the first channel region.

In a second aspect of the present disclosure, a device structure is disclosed. The device structure comprises a semiconductor structure comprising a drain-cathode electrode, a substrate over the drain-cathode electrode, and a body region over the substrate. The body region comprises a top surface, a first source region extending into the body region from the top surface, a first
U-shaped gate region having a portion below the first source region and defining a first gate trench, and a U-shaped anode region having a first portion below the first source region and defining an anode trench. The semiconductor structure further comprises a first source electrode over the first source region and between the first gate trench and the anode trench, a first gate electrode over a portion of a bottom surface of the first gate trench, an anode electrode over a portion of a bottom of the anode trench, wherein the first source electrode and the anode electrode are electrically coupled, the first gate region forms part of a first vertical junction field-effect transistor (JFET) cell, and the anode region forms part of a vertical diode cell, which is coupled anti-parallel with the first vertical JFET cell. The device structure further comprises a metal oxide semiconductor field-effect transistor (MOSFET) comprising a gate electrode, a source electrode, and a drain electrode, wherein the drain electrode of the MOSFET is coupled in series to the first source electrode of the first vertical JFET cell coupled anti-parallel with the vertical diode cell, forming a dual-gate cascode FET device.

In an embodiment, the semiconductor structure further comprises a second source region extending into the body region from the top surface, a second U-shaped gate region having a portion below the second source region and defining a second gate trench, wherein the anode region has a second portion below the second source region such that the anode trench is between the first gate trench and the second gate trench, a second source electrode over the second source region and between the second gate trench and the anode trench, a second gate electrode over a portion of a bottom surface of the second gate trench, wherein the first source electrode, the second source electrode, and the anode electrode are electrically coupled, and wherein the second gate region forms part of a second vertical JFET cell located on the opposite side of the first vertical JFET cell from the vertical diode cell, and the vertical diode cell is coupled anti-parallel with the first vertical JFET cell and the second vertical JFET cell.

In a third aspect of the present disclosure a method of fabricating a semiconductor structure is disclosed. The method comprises providing a drain-cathode electrode, providing a substrate over the drain-cathode electrode, providing a body region over the substrate wherein the body region comprises a top surface, a first source region extending into the body region from the top surface, a first U-shaped gate region having a portion below the first source region and defining a first gate trench, and a U-shaped anode region having a first portion below the first source region and defining an anode trench. The method further comprises providing a first source electrode over the first source region and between the first gate trench and the anode trench, providing a first gate electrode over a portion of a bottom surface of the first gate trench, providing an anode electrode over a portion of a bottom of the anode trench, and electrically coupling the first source electrode and the anode electrode such that the first gate region forms part of a first vertical junction field-effect transistor (JFET) cell, and the anode region forms part of a vertical diode cell, which is coupled anti-parallel with the first vertical JFET cell.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
FIGS. 1A and 1B illustrate cross-sectional views of embodiments of depletion-mode trench gate vertical junction field-effect transistors (VJFETs) with integrated source-drain anti-parallel diodes.
FIG. 2 shows an dual-gate cascode FET configuration comprising a plurality of alternating trench VJFET cells and anti-parallel source-drain diode cells connected in series with a metal oxide semiconductor field-effect transistor (MOSFET).
FIG. 3 illustrates a perspective view of a trench VJFET with an integrated anti-parallel source-drain diode forming a single unit cell having a gate-drain capacitance C_{GD} and a gate-source capacitance C_{GS}.
FIG. 4 depicts the electron flow lines through a single unit cell embodiment as illustrated schematically with flow lines.
FIGS. 5A-5C depict embodiments of single unit cells having one or more secondary vertical channel regions.
FIG. 6 is a perspective top view layout of a single unit cell embodiment as shown in FIG. 3.
FIG. 7 is a perspective top view layout of altering depletion-mode trench gate VJFETs with integrated source-drain anti-parallel diodes.
FIG. 8 shows a modeled curve chart of saturation current density (Jₛₐₜ) versus the specific on-resistance (R_{DS}A) for a single unit cell embodiment as shown in FIG. 3.
FIG. 9 shows a modeled curve chart of saturation current density (Jₛₐₜ) versus the threshold voltage (Vₜₕ) for a single unit cell embodiment as shown in FIG. 3.
FIG. 10 shows a modeled curve chart of gate-source breakdown voltage (BV_{GS}) versus the threshold voltage (Vₜₕ) for a single unit cell embodiment as shown in FIG. 3.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It should be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It should also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It should be understood that, although the terms "upper," "lower," "bottom," "intermediate," "middle," "top," and the like may be used herein to describe various elements, these elements should not be limited by these terms. These terms are only used to distinguish one element from another. For example, a first element could be termed an "upper" element and, similarly, a second element could be termed an "upper" element depending on the relative orientations of these elements, without departing from the scope of the present disclosure.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having meanings that are consistent with their meanings in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently

### re-described.

Conventional trench vertical junction field-effect transistor (VJFET) structures are created by etching trenches into a topside of a semiconductor material wherein gate regions are formed on both sides and bottoms of the trenches such that mirror-image replicates of gate regions and gate electrodes are formed on either side of each channel region. Therefore, both electrodes on either side of channel regions of conventional VJFETs are gate electrodes, controlling the current flow between drain and source, and creating a high gate-drain capacitance (C_{GD}) and gate-source capacitance (C_{GS}). Furthermore, in conventional VJFETs a reverse current (also referred to as source-drain current or 3rd quadrant current) conduction path does not exist, and current flow between drain and source approaches zero during their operation in the off-state. Such feature, namely having a bi-directional current flow or providing a 3rd quadrant current-conduction path with a reduced source-drain voltage (V_{SD}) drop, may be utilized in power converter topologies and applications.

Moreover, while a dual gate cascode structure of a VJFET in series with a low-voltage metal oxide semiconductor field-effect transistor (MOSFET) (herein after referred to as the "cascode structure") reduces the on-state resistance by driving the VJFET into positive V_{GS} values and provides an improved control of switching characteristics by enabling the gate of the VJFET device to be directly driven, nonetheless, cascode structures utilized in hard switching applications experience excessive 3rd quadrant energy losses due to the 3rd quadrant current (I_{SD}) flowing through the VJFET channel region and the source-drain voltage (V_{SD}) exceeding the absolute value of VJFET's threshold voltage (Vₜₕ).

Embodiments of the present disclosure provide VJFETs monolithically integrated with anti-parallel PN diodes. These structures can be applied to a variety of semiconductor devices including but not limited to other types of transistors and diodes and to other e-channel and p-channel JFET structures. A normally-off operation mode can be implemented by connecting the normally-on VJFET with an anti-parallel diode structure to a low-voltage MOSFET in a cascode configuration.

Merely by way of example, the concepts described herein have been applied to integration of these structures in silicon carbide (SiC) or gallium nitride (GaN). Other wide bandgap materials may be used for the integration of various embodiments disclosed herein. Alternatively, silicon (Si) (another primary semiconductor used in power electronic devices) may be used for the integration of various embodiments disclosed herein. SiC material properties make SiC JFETs attractive for high power conversion and high-power density applications. SiC JFETs are also of great interest in power electronic circuits for high-frequency power applications or circuit protection functions due to their superior performance compared with similar devices built on silicon.

It is to be appreciated that certain features of the disclosure which are, for clarity, described herein in the context of separate embodiments may also be provided in combination in a single embodiment. Conversely, various features of the present disclosure that are, for brevity, described in the context of a single embodiment may also be provided separately or in any sub-combination.

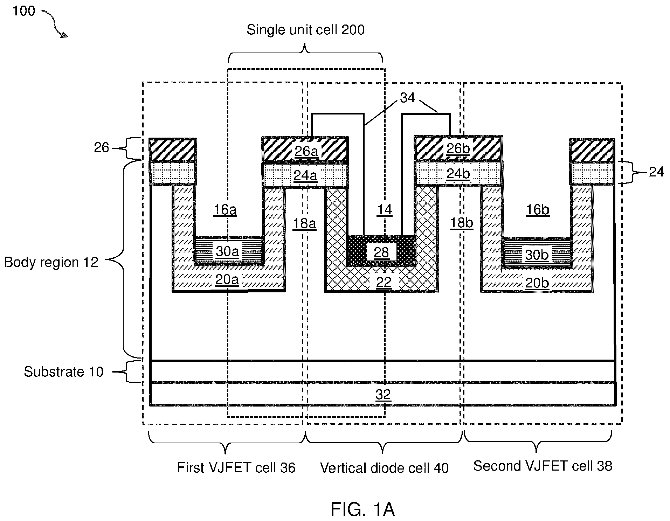

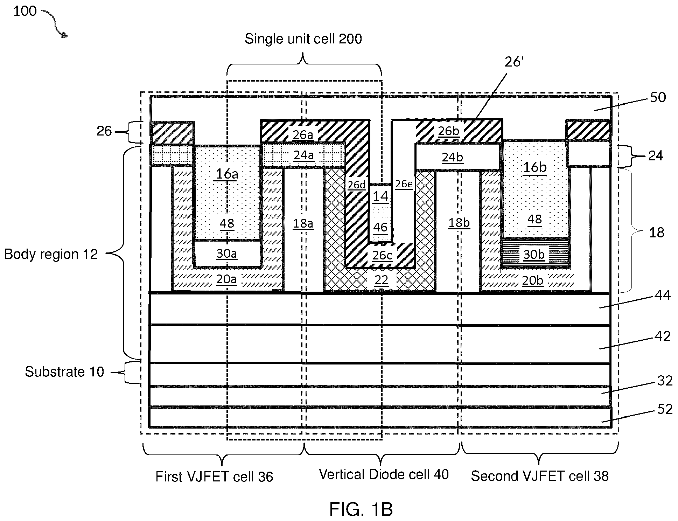

FIGS. 1A and 1B illustrate cross-sectional views of embodiments of depletion-mode trench gate VJFETs with integrated source-drain anti-parallel diodes. It should be understood that the structures illustrated in FIGS. 1A and 1B are and are simplified and that the scope of the present disclosure is not limited to these specific examples. Furthermore, the dimensions in the figures of this application are not to scale, and at times the relative dimensions are exaggerated or reduced in size to more clearly show various structural features.

While only three trenches are shown in each figure, it is to be understood that the structures illustrated may be replicated many times in an actual semiconductor device. Also, while due to the higher mobility of electrons compared with that of holes in SiC, the majority carriers in structures illustrated in these figures are electrons. It is further to be understood that the structures illustrated may be replicated with holes as the majority carriers in the case of which polarity signs and the directions of electric field and electric flux density may be reversed.

FIG. 1A illustrates a cross-sectional view of an embodiment of depletion-mode trench gate vertical JFETs (VJFETs) with integrated source-drain anti-parallel diodes (herein after referred to as "VJFET-diode structure **100**") which are built on a wafer comprising a substrate **10** and a body region **12,** both of which are doped with an n-type dopant.

A source region **24** extends into a top surface of the body region **12** using an ion implantation or epitaxial growth process. An anode trench **14,** a first gate trench **16a,** and a second gate trench **16b** are formed by etching trenches into a top surface of the body region **12** such that each trench extends vertically downward into the body region **12** from the top surface thereof. Although
FIG. 1A illustrates examples of trenches according to some embodiments of the present disclosure, it will be understood that the present disclosure is not limited to such configurations. For example, trenches adjacent to each other as described in the first embodiment may be of different depths or different widths. In various embodiments, adjacent trenches may dispose a different distance apart from one another.

The anode trench **14,** the first gate trench **16a,** and the second gate trench **16b** form a first source region **24a** and a second source region **24b** as part of the source region **24.** The first source region **24a** is formed under the top surface of the body region **12** between the first gate trench **16a** and the anode trench **14,** and the second source region **24b** is formed under the top surface of the body region **12** between the second gate trench **16b** and the anode trench **14.** The source region **24,** which includes the first source region **24a** and the second source region **24b,** is doped with an n+ dopant having a doping concentration ranging from 5e17 cm⁻³ to 1e21 cm⁻³. It should be appreciated that the thickness and doping concentration of the source region **24** may vary according to applications and fabrication processes.

Under the source region **24,** bottom and sidewalls surrounding each of the first gate trench **16a,** the second gate trench **16b,** and the anode trench **14** are doped with a p-type dopant to form a first gate region **20a,** a second gate region **20b,** and an anode region **22,** respectively, such that the first gate region **20a** forms a U-shaped region under the source region **24** that defines the first gate trench **16a** with a first portion of the U-shaped region under the first source region **24a.** Similarly, the anode region **22** forms a U-shaped region under the source region **24** to define the anode trench **14** with a first portion of the U-shaped region under the first source region **24a.**

The doping process is through ion implantation using vertical and/or angled implants and may combine multiple implantation energies and tilt and rotation angles and may be performed at high temperature (above room temperature) while the doping type of the dopant used is opposite that of the body region **12.** In one embodiment, trench sidewalls may be partially implanted or have a narrower doped region to reduce the structure's specific on-resistance (R_{ds}A). The doping type of the first gate region **20a,** the second gate region **20b,** and the anode region **22** are opposite those of the source region **24,** the body region **12,** and the substrate **10.** The first gate region **20a,** the second gate region **20b,** and the anode region **22** may have a doping concentration ranging from 1e17cm⁻³ to 5e20cm⁻³.

In practice, ohmic contacts may be used to reduce the contact resistance between the semiconductor and the metal electrodes and to enhance the overall conductance of the VJFET-diode structure **100.** Therefore, a first and a second source ohmic contacts (not shown here for simplicity and clarity) may form part of the first source region **24a** between the first gate trench **16a** and the anode trench **14** and of the second source region **24b** between the second gate trench **16b** and the anode trench **14.** The heavily doped n+ source region **24** forms PN junctions with the first gate region **20a,** the second gate region **20b,** and the anode region **22,** which facilitates gate control in the JFET cell. Similarly, a drain ohmic contact (not shown) may form part of a back surface of the substrate **10,** a first and a second gate ohmic contact (not shown) may form part of bottom surfaces of the first gate trench **16a** and the second gate trench **16b,** and an anode ohmic contact (not shown) may form part of a bottom surface of the anode trench **14.**

A first channel region **18a** and a second channel region **18b** form part of the body region **12.** The first channel region **18a** extends vertically into the body region **12** from below the first source region **24a** and forms laterally in between the first gate region **20a** and the anode region **22.** The second channel region **18b** extends vertically into the body region **12** below the second source region **24b** and forms laterally in between the anode region **22** and the second gate region **20b.** It should be noted that while only two channel regions are shown in FIG. 1A, the structures illustrated may be replicated many times to form a plurality of channel regions in a semiconductor device designed according to disclosures of the present application.

As shown in FIG. 1A, metal deposits over top surfaces of source regions **24** form source electrodes **26** including a first source electrode **26a** covering the top surface of the first source region **24a** and between the first gate trench **16a** and the anode trench **14** and a second source electrode **26b** covering the top surface of the second source region **24b** and between the second gate trench **16b** and the anode trench **14.** Similarly, metal regions over at least a portion of bottom surfaces of the first gate trench **16a** and a second gate trench **16b** provide a first gate electrode **30a** and a second gate electrode **30b.** Metal deposits over at least a portion of a bottom surface of the anode trench **14** provide an anode electrode **28,** and metal deposits over a backside surface of the substrate **10** provide a drain-cathode electrode **32.** Electrical couplings **34** are used to electrically connect each of the first source electrode **26a** and the second source electrode **26b** to the anode electrode **28** in order to hold the anode electrode **28** at the same electrical potential as the first source electrodes **26a** and the second source electrode **26b.**

In the simplified cross-sectional view of the embodiment shown in FIG. 1A, the anode electrode **28,** the anode region **22,** and the drain-cathode electrode **32** form part of a vertical diode cell **40.** As part of the same VJFET-diode structure **100,** the first source electrode **26a** and the first source region **24a** along with the drain-cathode electrode **32,** the first gate electrode **30a,** and the first gate region **20a** form part of a first VJFET cell **36.** Similarly, the second source electrode **26b** and the second source region **24b** along with the drain-cathode electrode **32,** the second gate electrode **30b,** and the second gate region **20b** form part of a second VJFET cell **38,** which is located on the opposite side of the first VJFET cell **36** from the vertical diode cell **40,** and the vertical diode cell **40** is coupled anti-parallel with the first VJFET cell **36** and the second VJFET cell **38.**

A single unit cell **200** as shown in the embodiment of FIG. 1A includes portions of the first VJFET cell **36** and portions of the vertical diode cell **40** adjacent to it. The integration of the source-drain anti-parallel diode into the depletion-mode trench VJFET semiconductor structure allows a 3rd quadrant current conduction while the VJFET is in off-state with a significant reduction of saturation current density (Jₛₐₜ) and maintaining a similar threshold voltage (Vₜₕ) and specific on-resistance (R_{ds}A).

FIG. 1B shows a cross-sectional view of an embodiment of depletion-mode trench gate VJFET with integrated source-drain anti-parallel diodes (herein after referred to as "VJFET-diode structure **100**"). As shown in FIG. 1B, the body region **12** may further comprise an n-type drift layer **42** configured to withstand a desired blocking voltage. The drift layer **42** may form above the substrate **10** and have a doping level in the range of 2e14cm⁻³ to 5e16cm⁻³. The doping level of the body region **12** may be in the ranges of 2e14cm⁻³ to 1e17cm⁻³, and the doping level of the substrate **10** may be in the range of 2e17cm⁻³ to 1e19cm⁻³.

The body region **12** comprises channel regions **18** including the first channel region **18a** and the second channel region **18b.** The first channel region **18a** forms below the first source region **24a** and between the first gate region **20a** and the anode region **22.** The second channel region **18b** forms below the second source region **24b** and between the second gate region **20b** and the anode region **22.** The doping level of the channel regions **18,** including the first channel region **18a** and the second channel region **18b,** may be at least two times lower than the lowest doping concentration in the rest of the body region **12** and in the range of 1e14cm⁻³ to 2e16cm⁻³.

The body region **12** may also comprise an n-type current spreading layer **44,** which may have a doping level in the range of 1e16cm⁻³ to 1e17cm⁻³. The current spreading layer **44** may be continuous or segmented and form above the drift layer **42** with its upper boundary positioned below the first gate region **20a** and the second gate region **20b.** The current spreading layer **44** may further comprise a plurality of other layers of different doping levels formed epitaxially and/or by ion implantation.

Optionally, a heavily doped N-type buffer layer (not shown here) may form over a top surface of the substrate **10** by means of epitaxial growth. It is further noted that while the body region **12,** the substrate **10,** the first channel region **18a,** and the second channel region **18b,** buffer, the current spreading layer **44,** and source regions **24** including the first source region **24a** and the second source region **24b** are depicted to have had been doped with an n-type dopant, and while a gate region **20** and the anode region **22** are shown with a p-type dopant, in practice, the doping types can be switched among these same structures.

In an embodiment, the first source electrode **26a** and the anode electrode **28** integrally form part of a continuous electrode structure **26'** that covers over at least a portion of the first source region **24a** to provide the first source electrode **26a,** a portion of a first side wall of the anode region **22** adjacent to the first source electrode **26a** to form a first sidewall electrode **26d,** and a portion of the bottom of anode trench **14** to form a bottom surface (anode) electrode **26c.** According to another embodiment, the first source electrode **26a** and the anode electrode **28** integrally form part of the continuous electrode structure **26'** that covers over at least a portion of the first source region **24a** to provide the first source electrode **26a,** the first side wall of the anode region **22** adjacent to the first source electrode **26a** to form the first sidewall electrode **26d,** and the bottom of anode trench **14** to form the bottom surface (anode) electrode **26c.**

The first source electrode **26a,** the second source electrode **26b,** and the anode electrode **28** may integrally form part of a continuous electrode structure **26'** that covers at least a portion of the first source region **24a** to provide the first source electrode **26a,** a portion of the first side wall of the anode region **22** adjacent to the first source electrode **26a** to form the first sidewall electrode **26d,** a portion of the bottom of anode trench **14** to form the bottom surface (anode) electrode **26c,** a portion of the second side wall of the anode region **22** adjacent to the second source electrode **26b** to form the second sidewall electrode **26e,** and at least a portion of the second source region **24b** to provide the second source electrode **26b.**

In yet another embodiment, the first source electrode **26a,** the second source electrode **26b,** and the anode electrode **28** integrally form part of a continuous electrode structure **26'** that covers at least a portion of the first source region **24a** to provide the first source electrode **26a,** the first side wall of the anode region **22** adjacent to the first source electrode **26a** to form the first sidewall electrode **26d,** the bottom of anode trench **14** to form the bottom surface (anode) electrode **26c,** the second side wall of the anode region **22** adjacent to the second source electrode **26b** to form a second sidewall electrode **26e,** and at least a portion of the second source region **24b** to provide the second source electrode **26b.**

A mostly self-aligned silicidation (salicidation) process may be used to form a separated first and second gate electrodes **30a** and **30b,** a continuous electrode structure **26'** that couples the first source electrode **26a** of the first VJFET cell **36** with the bottom surface (anode) electrode **26c** of the vertical diode cell **40** and the second source electrode **26b** of the second VJFET cell **38.** The source metal for silicidation process may include, but not limited to, nickel and titanium. A drain-cathode electrode **32** may be formed by a combination of metal deposition and laser irradiation.

The structure of FIG. 1B depicts an embodiment wherein the first gate trench **16a** and the second gate trench **16b** are filled with a gate trench dielectric material **48.** The gate trench dielectric material **48** is used to ensure the electrical isolation of the first source electrode **26a** and the first gate electrode **30a** in the first VJFET cell **36** and the electrical isolation of the second source electrode **26b** and second gate electrode **30b** in the second VJFET cell **38.**

In an embodiment, the anode trench **14** is filled with an anode trench dielectric material **46.** A portion of the anode trench dielectric material **46** may be removed in order to maximize the exposure of the continuous electrode structure **26'.** The method and process of fabrication used may control the amount of anode trench dielectric material **46** that is removed from the anode trench **14.** In another embodiment, the anode trench dielectric material **46** is entirely removed from the anode trench **14,** allowing the trench to be fully filled with a first metal overlay **50.** The first metal overlay **50** is deposited over the topside of the semiconductor structure to form a thick metal overlay which improves the conductivity of source-anode electrical connection.

The first metal overlay **50** covers source electrodes **26** and the exposed portions of the continuous electrode structure **26'** while filling the anode trench **14** to replace the removed portions of the anode trench dielectric material **46** to form contact with portions of the first sidewall electrode **26d** and the second sidewall electrode **26e.** The first metal overlay **50** may combine different metal sub-layers (not shown) including but not limited to metal layers composed of aluminum (Al), aluminum-copper (Al-Cu), copper (Cu), titanium (Ti), tungsten-titanium (TiW), tungsten (W), titanium nitride (TiN), palladium (Pd), and gold (Au).

In an embodiment, a final topside passivation layer (not shown) comprising a combination of chemical vapor deposition (CVD) dielectrics and polyimide may be deposited over the top surface of the first metal overlay **50** at a periphery of a semiconductor die used to fabricate VJFET-diode structure **100.**

A second metal overlay **52** is deposited at least partially over the backside of the drain-cathode electrode **32.** Multiple metallization layers (not shown) including one or more of Ni, Ti, TiW, TiN, W, Pd, Au, and silver (Ag) may comprise the second metal overlay **52.**

Basal plane defect (BPD) and stacking fault screening has to be implemented on starting an epitaxial wafer and at device level in the same manner as it is implemented in silicon carbide MOSFETs with built-in source-drain diode.

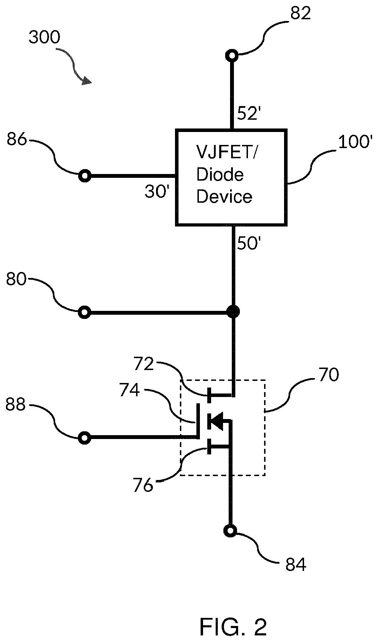

FIG. 2 shows an dual-gate cascode FET configuration **300** comprising a plurality of alternating trench VJFET cells and anti-parallel source-drain diode cells (herein after referred to as "VJFET/diode structure **100‴**) connected in series with a MOSFET **70.** The VJFET/diode structure **100'** comprises a unified drain electrode **52',** a unified gate electrode **30',** and a unified source electrode **50'.** The MOSFET **70** may be a low-voltage transistor having a MOSFET drain electrode **72,** a MOSFET gate electrode **74,** and a MOSFET source electrode **76.** The MOSFET drain electrode **72** is coupled to the unified source electrode **50'** of the VJFET/diode structure **100'** forming an intermediary electrode **80** for the dual-gate cascode FET configuration **300** having a drain electrode **82,** a source electrode **84,** a first gate electrode **86,** and a second gate electrode **88.** The first gate electrode **86** is the unified gate electrode **30'** of the VJFET/diode structure **100',** and the second gate electrode **88** is the MOSFET gate electrode **74.** The drain electrode **82** is the unified drain electrode **52'** of the VJFET/diode structure **100',** and the source electrode **84** is the MOSFET source electrode **76.** The dual-gate cascode FET configuration **300** reduces the on-resistance of VJFET/diode structure **100'.** The unified gate electrode **30'** of the VJFET/diode structure **100'** can be driven into positive V_{GS} values utilizing the first gate electrode **86,** which further improves controlling of switching behavior of the VJFET/diode structure **100'.** The second gate electrode **88,** which is the MOSFET gate electrode **74,** provides general on/off control for the dual-gate cascode FET configuration **300.**

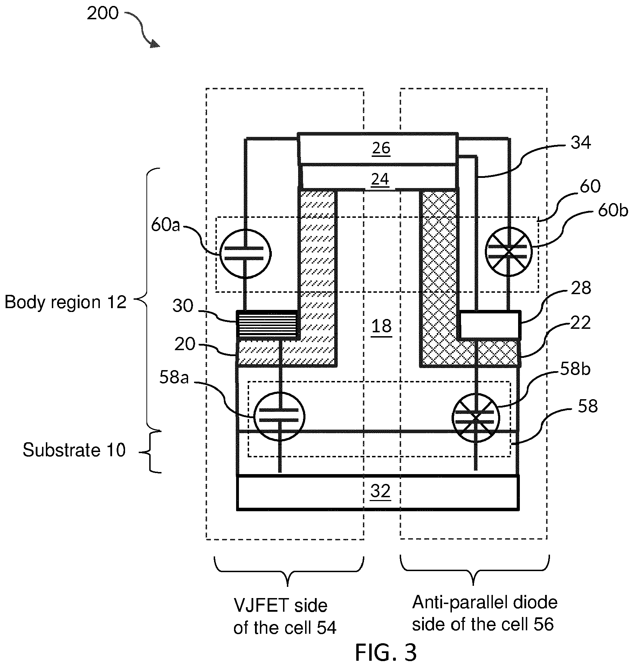

FIG. 3 illustrates a perspective view of a trench VJFET with an integrated anti-parallel source-drain diode forming a single unit cell **200** having a gate-drain capacitance C_{GD} **58** and a gate-source capacitance C_{GS} **60.** The single unit cell **200** comprises a VJFET side of the cell **54** and an anti-parallel diode side of the cell **56.** The VJFET side of the cell **54** comprises a gate region **20,** a source region **24,** a source electrode **26,** a gate electrode **30,** and a drain-cathode electrode **32.** The anti-parallel diode side of the cell **56** comprises an anode region **22,** an anode electrode **28,** and the drain-cathode electrode **32.** The source electrode **26** and the anode electrode **28** are electrically connected using an electrical coupling **34.** A channel region **18** forms under the source region **24** and extends vertically into the body region **12** and laterally in between the gate region **20** and the anode region **22.**

The integration of an anti-parallel source-drain diode within a trench VJFET structure to form the single unit cell **200** reduces the gate-drain capacitance C_{GD} **58** by approximately 50% to a first gate-drain capacitance C_{GD} **58a** and by eliminating a second gate-drain capacitance C_{GD} **58b.** Similarly, the integration of an anti-parallel source-drain diode within a trench VJFET structure to form the single unit cell **200** reduces the gate-source capacitance C_{GS} **60** by approximately 50% to a first gate-source capacitance C_{GS} **60a** and by eliminating a second gate-source capacitance C_{GS} **60b.**

Replacing a second gate electrode of the conventional VJFET (not shown) with the anode electrode **28** and electrically connecting the source electrode **26** to the anode electrode **28** forms an anti-parallel source-drain PN diode that eliminates associated parasitic capacitances with minimal impact on the on-resistance of the single unit cell **200.** Cancelled portions of the parasitic gate-drain capacitance C_{GD} **58** and the gate-source capacitance C_{GS} **60** improve the switching behavior of the single unit cell **200** with minimal impact on the on-state behavior of the device. Persons skilled in the art will appreciate that the aforementioned positive effect becomes more pronounced when multiple single unit cells **200** of a vertical trench JFET with integrated source-drain anti-parallel diodes are connected alternating and in parallel as shown in FIGS. 1A and 1B.

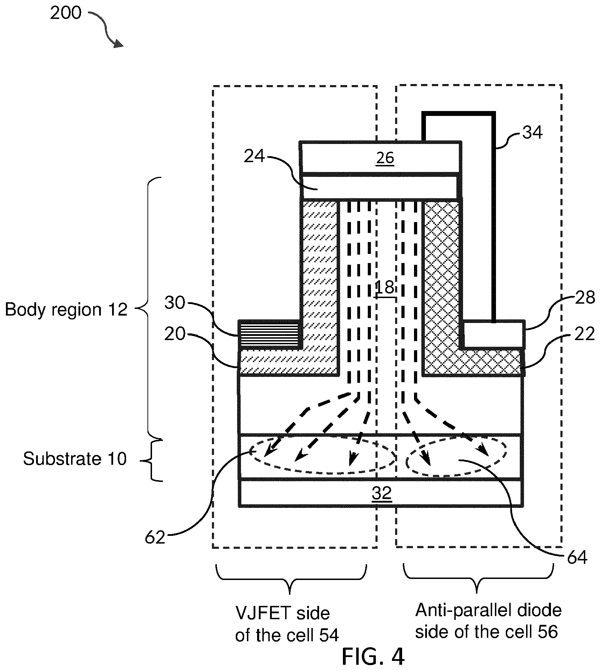

FIG. 4 depicts the electron flow lines (forward current flow is in the opposite direction) through a single unit cell **200** embodiment as illustrated schematically with electron flow lines. As shown in FIG. 4, in the 1^{st} quadrant of the conduction mode, forward current flow occurs through both the VJFET side of the cell **54** and the anti-parallel diode side of the cell **56.** The forward current through the VJFET side of the cell **54** as illustrated schematically with VJFET current flow lines **62** and the forward current through the diode side of the cell **56** as illustrated schematically with diode current flow lines **64** illustrate the minimal impact of integrating a source-drain anti-parallel diode within the device structure as forward current continues to spread efficiently through the entire structure.

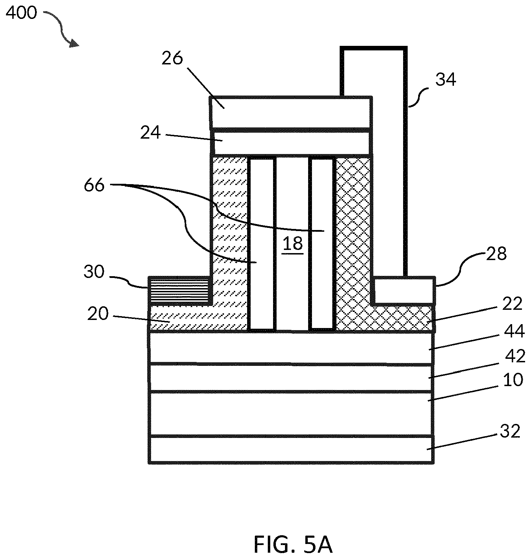

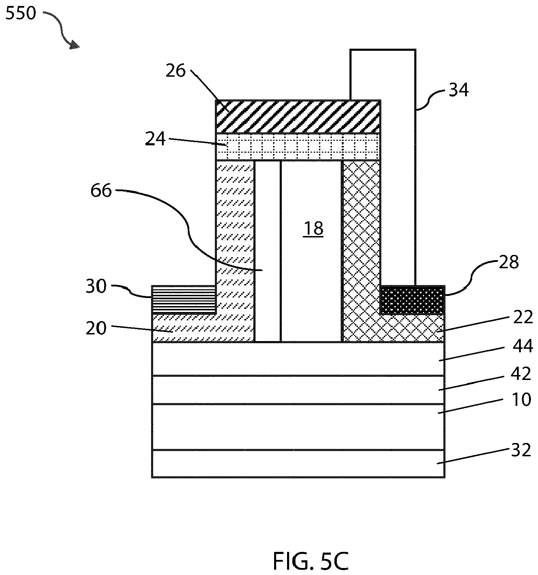

FIGS. 5A-5C depict embodiments of a first single unit cell **400,** a second single unit cell 500, and a third single unit cell **550,** respectively, each having one or more secondary vertical channel regions **66.** The one or more secondary vertical channel regions **66** as shown in FIGS. 5A and 5C may be formed either by angled ion implantation or by vertical ion implantation or a combination of both.

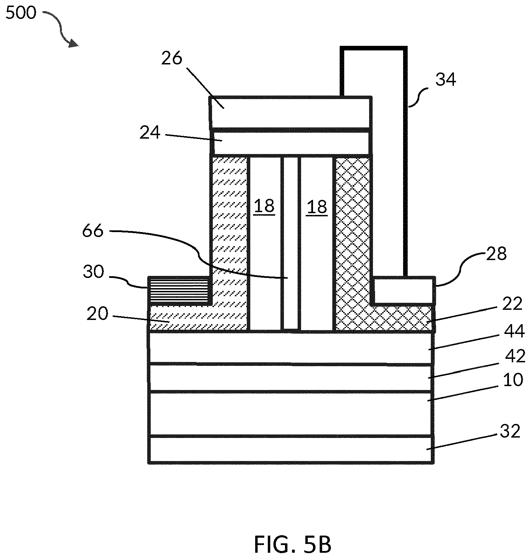

The doping levels of the channel region **18,** which may further comprise one or more secondary vertical channel regions **66,** affects the operation of the anti-parallel source-drain diode within a trench VJFET to form the single unit cell **200.** The threshold voltage (Vₜₕ) can be optimized through adjusting the doping level of the channel region **18** to a value that is much lower than that of the rest of the body region **12** and the substrate **10.** For example, the doping level of the channel region **18** may be at least two times lower than the lowest doping concentration in the rest of the body region **12** and in the range of 1e14cm⁻³ to 2e16cm⁻³. Furthermore, the maximum doping concentration of the one or more secondary vertical channel regions **66** as shown in FIGS. 5A and 5B may be at least 50% higher than the minimum concentration in the channel region **18.**

As illustrated in FIG. 5A, the channel region **18** may further comprise one or more secondary vertical channel regions **66,** wherein the one or more secondary vertical channel regions **66** run alongside the sidewalls of the channel region **18.** In one embodiment, the one or more secondary vertical channel regions **66** may have a maximum doping level that is at least 50% higher than minimum doping level in the channel region **18.**

FIG. 5B illustrates an embodiment of a secondary vertical channel region **66,** wherein the secondary vertical channel region **66** runs alongside the center of the channel region **18.** The secondary vertical channel region **66** as shown in FIG. 5B has a maximum doping level that is at least 50% higher than a minimum doping level of the channel region **18.**

FIG. 5C illustrates an embodiment of a secondary vertical region **66,** wherein the secondary vertical channel region **66** runs along the sidewall of the channel region **18** that is one the side of the gate electrode **30** but there is no secondary vertical region **66** on the sidewall on the side of the anode **28.** By placing the secondary vertical region **66** only on the sidewall adjacent to the gate electrode **30,** the process of manufacturing the third single unit cell **550** is simplified since secondary vertical channel region **66** only has to be implemented on one sidewall. Furthermore, in some embodiments, the benefit of having another secondary vertical channel region **66** along the side of the body like the first single unit cell **400** may be limited since the gate electrode **30** will primarily affect the operation of the adjacent secondary vertical channel in both forward conduction and off-state blocking..

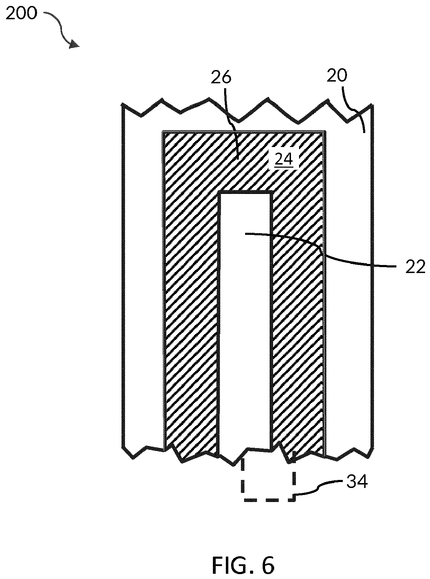

FIG. 6 is a perspective top view layout of a single unit cell embodiment **200** as shown in FIG. 3. In order to increase the current rating of the device, multiple single unit cells may be connected in parallel with the alternating gate regions **20** and the anode regions **22.** As shown in the top view layout of the single unit cell **200** embodiment, the anode region **22** is surrounded by the source region **24** mesa and the source region mesa **24** is itself surrounded by the gate region **20.** The electrical coupling **34** is used to electrically connect the anode electrode (not shown) to the source electrode **26** that is disposed over a top surface of the source region **24.**

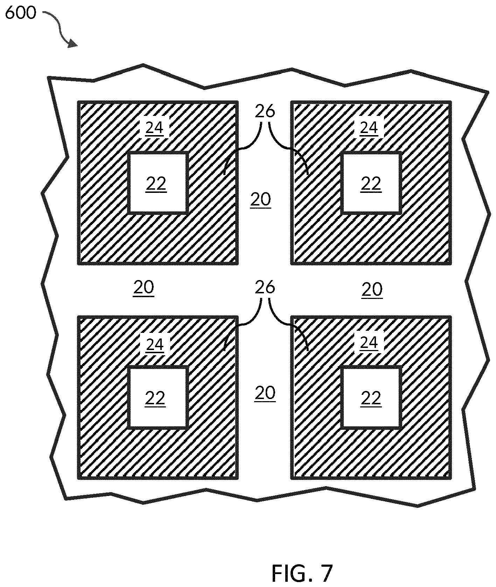

FIG. 7 is a perspective top view layout of altering depletion-mode trench gate vertical JFETs with an integrated source-drain anti-parallel diodes **600.** In an embodiment, the cell layout comprises the anode region **22** of multiple diode cells that are fully surrounded by source mesas (not shown) having the source electrode **26** over their top surfaces. The gate regions **20** form a grid pattern between the isolated anode regions **22** surrounded by source region **24** mesas covered with the source electrodes **26.**

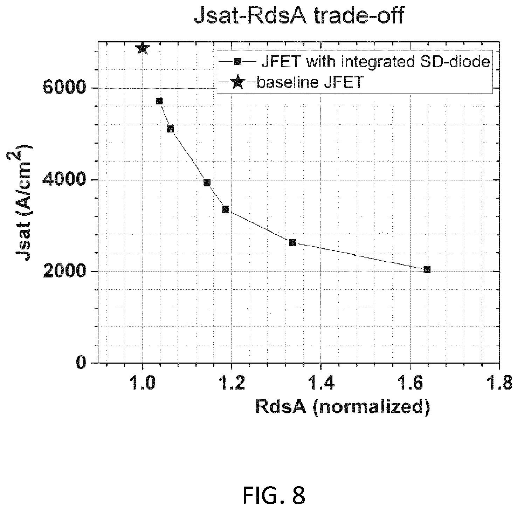

FIG. 8 shows a modeled curve chart of saturation current density (Jₛₐₜ) versus the specific on-resistance (R_{DS}A) for the single unit cell **200** embodiment of a trench VJFET with an integrated anti-parallel source-drain as shown in
FIG. 3 under operation values of V_{GS} = 0 V and V_{DS} = 800 V. The curve chart of FIG. 8 shows that compared with the baseline obtained from a conventional trench VJFET design with no integrated source-drain diode, the integration of a source-drain anti-parallel diode reduces Jₛₐₜ values by approximately 50% with minimal impact (approximately 20% increase) on R_{DS}A. The substantial reduction of Jₛₐₜ may significantly improve the short-circuit withstand time, allowing for more time for protective circuitry to shut-off the gate of the VJFET in case of a short-circuit event.

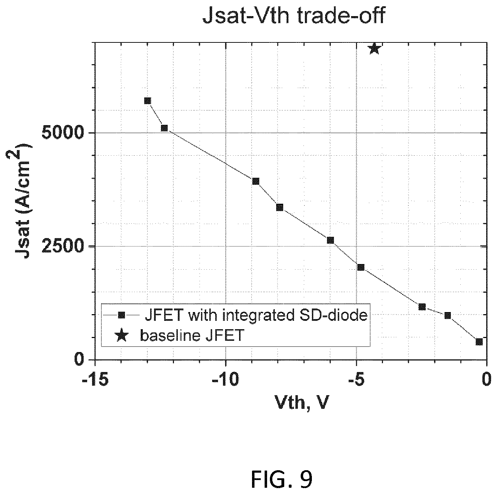

FIG. 9 shows a modeled curve chart of saturation current density (Jₛₐₜ) versus the threshold voltage (Vₜₕ) for the single unit cell **200** embodiment of a trench VJFET with an integrated anti-parallel source-drain as shown in FIG. 3 under operation values of V_{GS} = 0 V and V_{DS} = 800 V. The curve chart of FIG. 9 further illustrates that compared with the baseline obtained from a conventional trench VJFET design with no integrated source-drain diode, the integration of a source-drain anti-parallel diode into a trench VJFET structure allows for a significant reduction of saturation current density (Jₛₐₜ) with minimal impact on the threshold voltage (Vₜₕ).

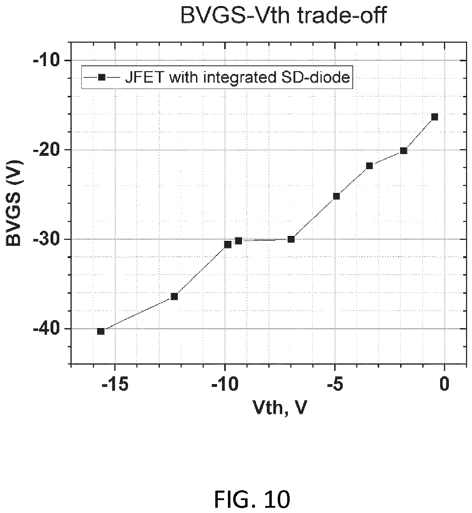

FIG. 10 shows a modeled curve chart of gate-source breakdown voltage (BV_{GS}) versus the threshold voltage (Vₜₕ) for the single unit cell **200** embodiment of a trench VJFET with an integrated anti-parallel source-drain as shown in FIG. 3. To turn off a normally-on VJFET device, a V_{GS} that is lower (more negative in value) than VJFET's threshold voltage (Vₜₕ) must be applied. However, such low value of V_{GS} may deplete the channel region **18** and result in a punch-through breakdown between the gate region **20** and the anode region **22.** As shown in the modeled curve chart, embodiments of the present disclosure provide improved design structures with significant safety margin values (in the range of 20V to 25V) between Vₜₕ and their corresponding BV_{GS}, resulting in a feasible structure for practical gate drive conditions.

A computer readable medium may include transitory or non-transitory type media such as physical storage media including storage discs and solid state devices. A computer readable medium may also or alternatively include transient media such as carrier signals and transmission media. A computer-readable storage medium is defined herein as a non-transitory memory device. A memory device includes memory space within a single physical storage device or memory space spread across multiple physical storage devices.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the preferred embodiments of the present disclosure. All such improvements and modifications are considered within the scope of the concepts disclosed herein and the claims that follow.

Thus, from one perspective, there have now been described vertical junction field-effect transistors (VJFETs) with integrated source-drain anti-parallel diodes. In an embodiment, a trench VJFET with integrated source-drain anti-parallel diodes structure is coupled with a low-voltage metal oxide semiconductor field-effect transistor (MOSFET) in a dual gate cascode configuration.

Further examples of feature combinations taught by the present disclosure are set out in the following numbered clauses:
1. A semiconductor structure comprising:
   a drain-cathode electrode;
   a substrate over the drain-cathode electrode;
   a body region over the substrate comprising:
      a top surface;
      a first source region extending into the body region from the top surface;
      a first U-shaped gate region having a portion below the first source region and defining a first gate trench; and
      a U-shaped anode region having a first portion below the first source region
      and defining an anode trench;
   a first source electrode over the first source region and between the first gate trench and the anode trench;
   a first gate electrode over a portion of a bottom surface of the first gate trench;
   an anode electrode over a portion of a bottom of the anode trench; and
   wherein the first source electrode and the anode electrode are electrically coupled,
   the first gate region forms part of a first vertical junction field-effect transistor (JFET) cell, and the anode region forms part of a vertical diode cell, which is coupled anti-parallel with the first vertical JFET cell.
2. The semiconductor structure of clause 1 wherein the substrate and the body region comprise silicon carbide.
3. The semiconductor structure of clause 1 or 2 wherein the first gate region and the anode region are doped with a p-type dopant and a remaining portion of the body region and the substrate are doped with an n-type dopant.
4. The semiconductor structure of any preceding clause wherein the first source electrode and the anode electrode integrally form part of a continuous electrode structure that covers at least a portion of the first source region, a portion of a first side wall of the anode trench, and a portion of the bottom of the anode trench.
5. The semiconductor structure of any preceding clause wherein the first source electrode and the anode electrode integrally form part of a continuous electrode structure that covers at least a portion of the first source region, a first side wall of the anode trench, and the bottom of the anode trench.
6. The semiconductor structure of any preceding clause wherein the body region further comprises a first channel region below the first source region and between the first gate region and the anode region.
7. The semiconductor structure of clause 6 further comprising a secondary channel region doped with an n-type dopant and extending vertically into a central region within the first channel region.
8. The semiconductor structure of clause 7 wherein a maximum doping concentration of the secondary channel region is at least 50% higher than a minimum doping concentration of the first channel region.
9. The semiconductor structure of clause 6 further comprising a pair of secondary channel regions doped with n-type dopants and extending on vertical inner walls within the first channel region.
10. The semiconductor structure of clause 9 wherein a maximum doping concentration of the secondary channel regions is at least 50% higher than a minimum doping concentration of the first channel region.
11. The semiconductor structure of any preceding clause further comprising:
   a second source region extending into the body region from the top surface of the body region;
   a second U-shaped gate region having a portion below the second source region and defining a second gate trench, wherein the anode region has a second portion below the second source region such that the anode trench is between the first gate trench and the second gate trench;
   a second source electrode over the second source region and between the second gate trench and the anode trench; and
   a second gate electrode over a portion of a bottom surface of the second gate trench, wherein the first source electrode, the second source electrode, and the anode electrode are electrically coupled; and
   wherein the second gate region forms part of a second vertical JFET cell located on the opposite side of the first vertical JFET cell from the vertical diode cell, and the vertical diode cell is coupled anti-parallel with the first vertical JFET cell and the second vertical JFET cell.
12. The semiconductor structure of clause 11 wherein the substrate and the body region comprise silicon carbide.
13. The semiconductor structure of clause 11 or 12 wherein the first gate region, the second gate region, and the anode region are doped with a p-type dopant and remaining portions of the body region and the substrate are doped with an n-type dopant.
14. The semiconductor structure of any of clauses 11-13 wherein the first source electrode, the second source electrode, and the anode electrode integrally form part of a continuous electrode structure that covers at least a portion of the first source region, at least a portion of the second source region, a portion of a first side wall of the anode trench, a portion of the bottom of the anode trench, and a portion of a second side wall of the anode trench.
15. The semiconductor structure of any of clauses 11-14 wherein the first source electrode, the second source electrode, and the anode electrode integrally form part of a continuous electrode structure that covers at least a portion of the first source region, a portion of the second source region, a first side wall of the anode trench, the bottom of the anode trench, and a second side wall of the anode trench.
16. The semiconductor structure of clause 15 further comprising a dielectric material filling portions of the first gate trench and the second gate trench to isolate the first gate electrode from the first source electrode and to isolate the second gate electrode from the second source electrode.
17. The semiconductor structure of clause 16 further comprising a first metal overlay over the first source electrode, the second source electrode, the first gate trench, the anode trench, and the second gate trench.
18. The semiconductor structure of clause 11 wherein the body region further comprises a drift layer above the substrate and doped with an n-type dopant.
19. The semiconductor structure of clause 18 wherein the body region further comprises a current spreading layer above the drift layer and below the first gate region and the second gate region and doped with an n-type dopant.
20. The semiconductor structure of any of clauses 11-19 wherein the body region further comprises a first channel region below the first source region and between the first gate region and the anode region and a second channel region below the second source region between the second gate region and the anode region.
21. The semiconductor structure of clause 20 further comprising a first secondary channel region doped with an n-type dopant and extending vertically into a central region of the first channel region and a second secondary channel region doped with an n-type dopant and extending vertically into a central region of the second channel region.
22. The semiconductor structure of clause 21 wherein a maximum doping concentration of the secondary channel region is at least 50% higher than a minimum doping concentration of the first channel region.
23. The semiconductor structure of clause 20 further comprising a first pair of secondary channel regions doped with an n-type dopant and extending on vertical inner walls within the first channel region and a second pair of secondary channel regions doped with an n-type dopant and extending on vertical inner walls within the second channel region.
24. The semiconductor structure of clause 23 wherein maximum doping concentrations of the first pair of secondary channel regions and the second pair of secondary channel regions are at least 50% higher than a minimum doping concentration of the first channel region.
25. A device structure comprising:
   a semiconductor structure comprising:
      a drain-cathode electrode;
      a substrate over the drain-cathode electrode;
      a body region over the substrate comprising:
         a first source region extending into the body region from a top surface of the body region;
         a first U-shaped gate region having a portion below the first source region and defining a first gate trench; and
         a U-shaped anode region having a first portion below the first source region and defining an anode trench;
      a first source electrode over the first source region and between the first gate trench and the anode trench;
      a first gate electrode over a portion of a bottom surface of the first gate trench;
      an anode electrode over a portion of a bottom of the anode trench; and
      wherein the first source electrode and the anode electrode are electrically coupled, the first gate region forms part of a first vertical junction field-effect transistor (JFET) cell, and the anode region forms part of a vertical diode cell, which is coupled anti-parallel with the first vertical JFET cell;
   a metal oxide semiconductor field-effect transistor (MOSFET) comprising a gate electrode, a source electrode, and a drain electrode; and
   wherein the drain electrode of the MOSFET is coupled in series to the first source electrode of the first vertical JFET cell coupled anti-parallel with the vertical diode cell, forming a dual-gate cascode FET device.
26. The device structure of clause 25 wherein the semiconductor structure further comprises:
   a second source region extending into the body region from the top surface of the body region;
   a second U-shaped gate region having a portion below the second source region and defining a second gate trench, wherein the anode region has a second portion below the second source region such that the anode trench is between the first gate trench and the second gate trench;
   a second source electrode over the second source region and between the second gate trench and the anode trench;
   a second gate electrode over a portion of a bottom surface of the second gate trench, wherein the first source electrode, the second source electrode, and the
   anode electrode are electrically coupled; and
   wherein the second gate region forms part of a second vertical JFET cell located on the opposite side of the first vertical JFET cell from the vertical diode cell, and the vertical diode cell is coupled anti-parallel with the first vertical JFET cell and the second vertical JFET cell.
27. A method of fabricating a semiconductor structure comprising:
   providing a drain-cathode electrode;
   providing a substrate over the drain-cathode electrode;
   providing a body region over the substrate comprising:
      a first source region extending into the body region from a top surface of the body region;
      a first U-shaped gate region having a portion below the first source region and defining a first gate trench; and
      a U-shaped anode region having a first portion below the first source region
      and defining an anode trench;
   providing a first source electrode over the first source region and between the first gate trench and the anode trench;
   providing a first gate electrode over a portion of a bottom surface of the first gate trench;
   providing an anode electrode over a portion of a bottom of the anode trench; and
   electrically coupling the first source electrode and the anode electrode such that the first gate region forms part of a first vertical junction field-effect transistor (JFET) cell, and the anode region forms part of a vertical diode cell, which is coupled anti-parallel with the first vertical JFET cell.

## Claims

1. A semiconductor structure comprising:
a drain-cathode electrode;
a substrate over the drain-cathode electrode;
a body region over the substrate comprising:
a top surface;
a first source region extending into the body region from the top surface;
a first U-shaped gate region having a portion below the first source region and defining a first gate trench; and
a U-shaped anode region having a first portion below the first source region and defining an anode trench;
a first source electrode over the first source region and between the first gate trench and the anode trench;
a first gate electrode over a portion of a bottom surface of the first gate trench;
an anode electrode over a portion of a bottom of the anode trench; and
wherein the first source electrode and the anode electrode are electrically coupled, the first gate region forms part of a first vertical junction field-effect transistor (JFET) cell, and the anode region forms part of a vertical diode cell, which is coupled anti-parallel with the first vertical JFET cell.

2. The semiconductor structure of claim 1 wherein the substrate and the body region comprise silicon carbide.

3. The semiconductor structure of claim 1 or 2 wherein the first gate region and the anode region are doped with a p-type dopant and a remaining portion of the body region and the substrate are doped with an n-type dopant.

4. The semiconductor structure of any preceding claim wherein the first source electrode and the anode electrode integrally form part of a continuous electrode structure that covers at least a portion of the first source region, at least a portion of a first side wall of the anode trench, and at least a portion of the bottom of the anode trench.

5. The semiconductor structure of any preceding claim wherein the body region further comprises a first channel region below the first source region and between the first gate region and the anode region.

6. The semiconductor structure of claim 5 further comprising a secondary channel region doped with an n-type dopant and extending vertically into a central region within the first channel region, and optionally wherein a maximum doping concentration of the secondary channel region is at least 50% higher than a minimum doping concentration of the first channel region.

7. The semiconductor structure of claim 5 further comprising a pair of secondary channel regions doped with n-type dopants and extending on vertical inner walls within the first channel region, and optionally wherein a maximum doping concentration of the secondary channel regions is at least 50% higher than a minimum doping concentration of the first channel region.

8. The semiconductor structure of any preceding claim further comprising:
a second source region extending into the body region from the top surface of the body region;
a second U-shaped gate region having a portion below the second source region and defining a second gate trench, wherein the anode region has a second portion below the second source region such that the anode trench is between the first gate trench and the second gate trench;
a second source electrode over the second source region and between the second gate trench and the anode trench; and
a second gate electrode over a portion of a bottom surface of the second gate trench, wherein the first source electrode, the second source electrode, and the
anode electrode are electrically coupled; and
wherein the second gate region forms part of a second vertical JFET cell located on the opposite side of the first vertical JFET cell from the vertical diode cell, and the vertical diode cell is coupled anti-parallel with the first vertical JFET cell and the second vertical JFET cell.

9. The semiconductor structure of claim 8 wherein the first gate region, the second gate region, and the anode region are doped with a p-type dopant and remaining portions of the body region and the substrate are doped with an n-type dopant.

10. The semiconductor structure of claim 8 or 9 wherein the first source electrode, the second source electrode, and the anode electrode integrally form part of a continuous electrode structure that covers at least a portion of the first source region, at least a portion of the second source region, at least a portion of a first side wall of the anode trench, at least a portion of the bottom of the anode trench, and at least a portion of a second side wall of the anode trench.

11. The semiconductor structure of any of claims 8-10 further comprising a dielectric material filling portions of the first gate trench and the second gate trench to isolate the first gate electrode from the first source electrode and to isolate the second gate electrode from the second source electrode, and optionally further comprising a first metal overlay over the first source electrode, the second source electrode, the first gate trench, the anode trench, and the second gate trench.

12. The semiconductor structure of any of claims 8-12 wherein the body region further comprises a drift layer above the substrate and doped with an n-type dopant, and optionally wherein the body region further comprises a current spreading layer above the drift layer and below the first gate region and the second gate region and doped with an n-type dopant.

13. A device structure comprising:
a semiconductor structure comprising:
a drain-cathode electrode;
a substrate over the drain-cathode electrode;
a body region over the substrate comprising:
a first source region extending into the body region from a top surface of the body region;
a first U-shaped gate region having a portion below the first source region and defining a first gate trench; and
a U-shaped anode region having a first portion below the first source region and defining an anode trench;
a first source electrode over the first source region and between the first gate trench and the anode trench;
a first gate electrode over a portion of a bottom surface of the first gate trench;
an anode electrode over a portion of a bottom of the anode trench; and
wherein the first source electrode and the anode electrode are electrically coupled, the first gate region forms part of a first vertical junction field-effect transistor (JFET) cell, and the anode region forms part of a vertical diode cell, which is coupled anti-parallel with the first vertical JFET cell;
a metal oxide semiconductor field-effect transistor (MOSFET) comprising a gate electrode, a source electrode, and a drain electrode; and
wherein the drain electrode of the MOSFET is coupled in series to the first source electrode of the first vertical JFET cell coupled anti-parallel with the vertical diode cell, forming a dual-gate cascode FET device.

14. The device structure of claim 13 wherein the semiconductor structure further comprises:
a second source region extending into the body region from the top surface of the body region;
a second U-shaped gate region having a portion below the second source region and defining a second gate trench, wherein the anode region has a second portion below the second source region such that the anode trench is between the first gate trench and the second gate trench;
a second source electrode over the second source region and between the second gate trench and the anode trench;
a second gate electrode over a portion of a bottom surface of the second gate trench, wherein the first source electrode, the second source electrode, and the
anode electrode are electrically coupled; and
wherein the second gate region forms part of a second vertical JFET cell located on the opposite side of the first vertical JFET cell from the vertical diode cell, and the vertical diode cell is coupled anti-parallel with the first vertical JFET cell and the second vertical JFET cell.

15. A method of fabricating a semiconductor structure comprising:
providing a drain-cathode electrode;
providing a substrate over the drain-cathode electrode;
providing a body region over the substrate comprising:
a first source region extending into the body region from a top surface of the body region;
a first U-shaped gate region having a portion below the first source region and defining a first gate trench; and
a U-shaped anode region having a first portion below the first source region and defining an anode trench;
providing a first source electrode over the first source region and between the first gate trench and the anode trench;
providing a first gate electrode over a portion of a bottom surface of the first gate trench;
providing an anode electrode over a portion of a bottom of the anode trench; and
electrically coupling the first source electrode and the anode electrode such that the first gate region forms part of a first vertical junction field-effect transistor (JFET) cell, and the anode region forms part of a vertical diode cell, which is coupled anti-parallel with the first vertical JFET cell.
